# EUROPÄISCHE PATENTSCHRIFT

(11) **EP 2 425 469 B1**
(45) Veröffentlichungstag und Bekanntmachung des Hinweises auf die Patenterteilung: **09.01.2019**
(21) Anmeldenummer: 10721291.2
(22) Anmeldetag: 28.04.2010
(51) Int. Cl.: H01L 51/52, C03C 3/12, C03C 8/24

(54) **BAUTEIL MIT EINEM ERSTEN UND EINEM ZWEITEN SUBSTRAT UND VERFAHREN ZU DESSEN HERSTELLUNG**
PART HAVING A FIRST AND A SECOND SUBSTRATE AND METHOD FOR THE PRODUCTION THEREOF
ÉLÉMENT POURVU D'UN PREMIER ET D'UN SECOND SUBSTRAT ET SON PROCÉDÉ DE FABRICATION

(30) Priorität: 30.04.2009 DE 102009019518; 06.08.2009 DE 102009036395
(43) Veröffentlichungstag der Anmeldung: 07.03.2012
(73) Patentinhaber: OSRAM OLED GmbH, 93049 Regensburg (DE)
(72) Erfinder: EBERHARDT, Angela, 86157 Augsburg (DE); BEER, Ulrike, 86405 Meitingen (DE); WIRTH-SCHÖN, Joachim, 89312 Günzburg (DE); PÖSL, Ewald, 86438 Kissing (DE)
(74) Vertreter: Epping - Hermann - Fischer
(86) Internationale Anmeldenummer: PCT/DE2010/000491
(87) Internationale Veröffentlichungsnummer: WO 2010/124682

(56) Entgegenhaltungen:
- DE-A1- 2 222 771
- DE-A1- 4 128 804
- JP-A- 59 018 132
- JP-A- 2009 067 632
- US-A- 4 945 071
- US-A1- 2005 269 926
- US-A1- 2008 106 194
- US-B2- 6 998 776
- Ch. GEORGI, H. KERN: "Festkörper mit negativer thermischer Ausdehnung" Technische Universität Ilmenau, Institut für Werkstofftechnik 2004, XP002592542 Gefunden im Internet: URL:http://wcms1.rz.tu-ilmenau.de/fakmb/fi leadmin/template/fgmwv/PDF_Dateien/Publika tionen/2004/03_Georgi_ThWT04.pdf [gefunden am 2010-07-19] in der Anmeldung erwähnt

## Beschreibung

Die vorliegende Erfindung betrifft ein Bauteil mit einem ersten Substrat und einem zweiten Substrat. Weiterhin betrifft die Erfindung ein Verfahren zum Herstellen eines solchen Bauteils.

Organische, Licht emittierende Dioden (OLED), die zwischen zwei Substraten angeordnet sind, können mittels einer Klebstoffschicht abgedichtet werden. Die Klebstoffschicht befindet sich dabei zwischen den beiden Substraten. Der Kleber wird beispielsweise mit UV-Strahlung ausgehärtet. Da die Klebstoffschicht nicht vollständig sauerstoff- und wasserdampfdicht ist, können diese Gase mit der Zeit durch die Klebstoffschicht hindurch in die OLED eindiffundieren. Da die OLED nicht sauerstoff- und wasserstoffbeständig ist, kann dies zu einer Schädigung der OLED sowie zu einer Erniedrigung der Lebensdauer der OLED führen.

Um die Lebensdauer der OLED zu erhöhen, ist es möglich, eine Kavität in eines der Substrate auszubilden und in die Kavität einen Getter einzubringen.

Ein Getter ist insbesondere ein chemisch reaktives Material, das dazu dient, ein Vakuum möglichst lange zu erhalten. An der Oberfläche eines Getters gehen Gasmoleküle mit den Atomen des Gettermaterials eine direkte chemische Verbindung ein oder die Gasmoleküle werden durch Sorption festgehalten. Auf diese Weise werden Gasmoleküle "eingefangen".

Durch eine in eines der Substrate eingebrachte Kavität und durch einen in die Kavität eingebrachten Getter erhöhen sich jedoch nachteilig die Kosten und der Herstellungsaufwand solcher Bauteile.

Eine Vorrichtung, die zwei Substrate und eine dazwischen angeordnete OLED aufweist, ist beispielsweise aus den Druckschriften US 6,998,776 B2 oder US 2008/0106194 A1 bekannt.

Die Druckschrift JP 2009-067632 A betrifft ein Versiegelungsglas für eine optische Komponente.

Eine Beschreibung eines organischen, Licht emittierenden Displays findet sich in der Druckschrift US 2005/0269926 A1.

Glaskompositionen zur Versiegelung sind in den Druckschriften JP 59-018132 A und US 4,945,071 A zu finden.

Der Erfindung liegt die Aufgabe zugrunde, ein verbessertes Bauteil bereitzustellen, das ein organisches, optoelektronisches Bauelement vor Umwelteinflüssen schützt und gleichzeitig eine kostengünstige und vereinfachte Herstellung aufweist.

Diese Aufgaben werden durch ein Bauteil mit den Merkmalen des Patentanspruchs 1 und ein Verfahren zu dessen Herstellung mit den Merkmalen des Patentanspruchs 8 gelöst. Vorteilhafte Ausführungsformen und bevorzugte Weiterbildungen des Bauteils und des Verfahrens zu dessen Herstellung sind Gegenstand der abhängigen Ansprüche.

Erfindungsgemäß sind ein erstes Substrat und ein zweites Substrat vorgesehen, wobei auf dem ersten Substrat mindestens ein optoelektronisches Bauelement angeordnet ist, das mindestens ein organisches Material enthält.

Das erste Substrat und das zweite Substrat sind relativ zueinander derart angeordnet, dass das optoelektronische Bauelement zwischen dem ersten Substrat und dem zweiten Substrat angeordnet ist.

Erfindungsgemäß ist zwischen dem ersten Substrat und dem zweiten Substrat ein Verbindungsmaterial angeordnet, welches das optoelektronische Bauelement umschließt und das erste und zweite Substrat mechanisch miteinander verbindet. Bevorzugt umläuft das Verbindungsmaterial das optoelektronische Bauelement. Besonders bevorzugt umläuft das Verbindungsmaterial das optoelektronische Bauelement vollständig. Beispielsweise umschließt das Verbindungsmaterial das optoelektronische Bauelement rahmenförmig.

Erfindungsgemäß ist das Verbindungsmaterial silberoxidhaltig mit einem Anteil einschließlich zwischen 20 Gew.-% und 70 Gew.-%. Insbesondere rührt das Silberoxid nicht von Verunreinigungen her, sondern wird bewusst als Komponente oder Dotierung in das Verbindungsmaterial eingebracht.

Erfindungsgemäß umfasst das Verbindungsmaterial zumindest einen Füllstoff, der den thermischen Ausdehnungskoeffizienten des Verbindungsmaterials reduziert.

Erfindungsgemäß weist das Bauteil ein erstes Substrat und ein zweites Substrat auf, wobei auf dem ersten Substrat mindestens ein optoelektronisches Bauelement angeordnet ist, das mindestens ein organisches Material enthält. Das erste Substrat und das zweite Substrat sind relativ zueinander derart angeordnet, dass das optoelektronische Bauelement zwischen dem ersten Substrat und dem zweiten Substrat angeordnet ist. Zwischen dem ersten Substrat und dem zweiten Substrat ist ein Verbindungsmaterial angeordnet, welches das optoelektronische Bauelement umschließt und erstes und zweites Substrat mechanisch miteinander verbindet. Das Verbindungsmaterial umfasst Silberoxid zu einem Anteil von einschließlich 20 bis einschließlich 70 Gew-%. Ferner umfasst das Verbindungsmaterial zumindest einen Füllstoff, der den thermischen Ausdehnungskoeffizienten des Verbindungsmaterials ändert reduziert. Der Füllstoff weist einen negativen thermischen Ausdehnungskoeffizienten auf und ein Anteil des Füllstoffs am Verbindungsmaterial liegt unter 30 Volumen-%. Das Verbindungsmaterial umfasst ein bleifreies Glas und eine Komponente dieses Glases ist Vanadiumoxid. Die Substrate sind aus einem Kalknatronglas hergestellt. Elektrische Zuführungen des optoelektronischen Bauelements erfolgen auf einer dem optoelektronischen Bauelement zugewandten Oberfläche des ersten Substrats und eine der elektrischen Zuführungen ist von einem Kontakt des optoelektronischen Bauelements, welcher sich auf der von dem ersten Substrat abgewandten Seite des optoelektronischen Bauelements befindet, über eine Seitenfläche des optoelektronischen Bauelements zu dem ersten Substrat geführt. Die elektrischen Zuführungen des optoelektronischen Bauelements sind aus dem Verbindungsmaterial herausgeführt, sodass das Verbindungsmaterial über die elektrischen Zuführungen auf dem ersten Substrat hinweg geführt ist. Das erste Substrat überragt das zweite Substrat lateral, in Draufsicht auf das zweite Substrat gesehen, sodass das erste Substrat eine größere Grundfläche aufweist als das zweite Substrat.

Das optoelektronische Bauelement wird vorzugsweise vollständig von dem ersten Substrat, dem zweiten Substrat und dem Verbindungsmaterial umschlossen. Dabei bilden die zwei Substrate und das Verbindungsmaterial bevorzugt eine geschlossene Zelle, in der das optoelektronische Bauelement angeordnet ist. Die Zelle setzt sich dabei aus zwei Grundflächen, insbesondere dem ersten Substrat und dem zweiten Substrat, und Seitenflächen, insbesondere dem Verbindungsmaterial, zusammen, wobei die Seitenflächen die zwei Grundflächen miteinander verbinden.

Bevorzugt ist zwischen dem Verbindungsmaterial und dem optoelektronischen Bauelement ein Abstand angeordnet. Besonders bevorzugt ist das Verbindungsmaterial auf dem ersten Substrat neben dem optoelektronischen Bauelement angeordnet, wobei das Verbindungsmaterial von dem optoelektronischen Bauelement lateral beabstandet ist. Insbesondere steht das Verbindungsmaterial nicht in Berührung mit dem optoelektronischen Bauelement.

Der Schutz des organischen, optoelektronischen Bauelements insbesondere vor Umwelteinflüssen erfolgt insbesondere vorzugsweise durch das Verbindungsmaterial, das zwischen erstem und zweitem Substrat so angeordnet ist, dass das Verbindungsmaterial eine mechanische Verbindung zwischen erstem Substrat und zweitem Substrat darstellt.

Unter Umwelteinflüsse ist insbesondere das Eindringen von Luft und/oder Feuchtigkeit in das Bauteil zu verstehen. Das Eindringen von Luft oder Feuchtigkeit in das Bauteil würde zu einer Schädigung oder gar zu einer Zerstörung des organischen, optoelektronischen Bauelements führen.

Als Folge des Ausschlusses von Wasserdampf, Sauerstoff und Feuchtigkeit erhöht sich mit Vorteil die Lebensdauer des optoelektronischen Bauelements. Ferner reduziert sich mit Vorteil die Menge an Getter beziehungsweise entfällt dieser ganz. Dadurch ergibt sich mit Vorteil ein vereinfacht herstellbares und kostengünstig herstellbares Bauteil.

Der luftdichte Abschluss erfolgt vorzugsweise mittels des Verbindungsmaterials, welches Silberoxid enthält mit einem Anteil einschließlich zwischen 20 Gew.-% und 70 Gew.-% und zumindest ein Füllstoff umfasst, der den thermischen Ausdehnungskoeffizienten des Verbindungsmaterials reduziert.

Glaslote, die Silberoxid zu einem Anteil zwischen 20 bis 70 Gew-% umfassen sowie deren Herstellung sind beispielsweise in den Patentschriften DE 4 128 804 A1 und DE 2 222 771 A1 beschrieben.

Erfindungsgemäß umfasst das Verbindungsmaterial ein bleifreies Glas. Besonders bevorzugt ist das Verbindungsmaterial ein bleifreies Glas.

Bei einer weiteren bevorzugten Ausgestaltung umfasst das Verbindungsmaterial ein niedrigschmelzendes Glas. Bevorzugt ist das Verbindungsmaterial ein niedrigschmelzendes Glas.

Besonders bevorzugt ist das Verbindungsmaterial ein bleifreies und niedrigschmelzendes Glas.

Ein niedrigschmelzendes Glas ist insbesondere ein Glas, das einen sehr niedrigen Erweichungspunkt für Einbrenntemperaturen von unterhalb 600° C, bevorzugt unterhalb 500° C, besonders bevorzugt unterhalb 400° C, idealerweise unterhalb 350° C besitzt.

Bei einer bevorzugten Ausführungsform umfasst das Verbindungsmaterial eine Glasfritte. Eine Glasfritte ist insbesondere ein Zwischenprodukt bei der Herstellung von Glasschmelzen. Die Glasfritte entsteht durch oberflächliches Schmelzen von Glaspulver, wobei die Glaskörner zusammenschmelzen. Die Glasfritte besteht insbesondere aus einem porösen Material.

Bei einer weiteren Ausführungsform umfasst das Verbindungsmaterial ein Glaslot. Ein Glaslot zur Verkapselung eines Bauteils ist beispielsweise aus der Druckschrift US 6,936,963 B2 bekannt.

Erfindungsgemäß weist der Füllstoff einen negativen thermischen Ausdehnungskoeffizienten auf. Beispiele geeigneter Füllstoffe sind beispielsweise in dem Artikel "Festkörper mit negativer thermischer Ausdehnung" von Georgi, Ch. und Kern, H.; Technische Universität Ilmenau, Institut für Werkstofftechnik, beschrieben. Insbesondere wird auf die darin aufgeführten Tabellen 1 auf Seite 4 hingewiesen.

Erfindungsgemäß liegt der Anteil des Füllstoffs am Verbindungsmaterial unter 30 Volumen-%.

Bei einer bevorzugten Weiterbildung des Bauteils enthält das Verbindungsmaterial zumindest eine Komponente und/oder einen weiteren Füllstoff, der Strahlung absorbiert. Bevorzugt absorbieren die Komponente und/oder der weitere Füllstoff zumindest teilweise infrarote und/oder ultraviolette Strahlung. Vorzugsweise absorbiert das Verbindungsmaterial mit darin enthaltener Komponente und/oder weiterem Füllstoff 20 % infrarote und/oder ultraviolette Strahlung, bevorzugt 40 %, besonders bevorzugt 60 % und mehr.

Ein Verbindungsmaterial, das unter anderem weitere Füllstoffe mit absorbierenden Eigenschaften im Wellenlängenbereich infraroter oder ultravioletter Strahlung umfasst, weist mit Vorteil wärmeisolierende Eigenschaften auf. Ferner schützt ein in dem genannten Wellenlängenbereich absorbierendes Verbindungsmaterial das organische, optoelektronische Bauelement vor Sonneneinstrahlung.

Der weitere Füllstoff kann dabei insbesondere ein strahlungsabsorbierendes Element oder eine Verbindung sein. Beispielsweise ist der Füllstoff Vanadiumoxid, ein Spinell oder eine Spinellverbindung.

Ein Spinell ist insbesondere ein im kubischen Kristallsystem kristallierendes Magnesiumaluminiumoxidmineral mit der chemischen Formel MgAl₂O₄. Ferner eignen sich als weitere Füllstoffe, die absorbierende Eigenschaften aufweisen, Spinellverbindungen. Spinellverbindungen haben eine ähnliche Kristallstruktur wie Spinell und sind unter anderem chemische Verbindungen des allgemeinen Typs AP₂X₄, wobei A ein zweiwertiges Metallkation, P ein dreiwertiges Metallkation und X vorwiegend ein Oxid oder Sulfid ist. Beispiele für Spinellverbindungen sind unter anderem Magnesiumspinelle (MgAl₂O₄), Gahnite (ZnAl₂O₄) oder Kobaltspinelle (CoAl₂O₄) (Kobaltaluminat).

Der weitere Füllstoff kann beispielsweise Bestandteil des Verbindungsmaterials selbst sein. Alternativ kann der weitere Füllstoff nachträglich zu dem Verbindungsmaterial zugemischt sein.

Erfindungsgemäß sind das erste Substrat undr das zweite Substrat aus Fensterglas.

Unter Fensterglas ist ein kalkhaltiges natriumhaltiges Glas zu verstehen, das Kalziumkarbonat enthält. Weitere Karbonate und/oder Oxide sowie Verunreinigungen können ferner im Fensterglas enthalten sein. Ein solches Glas ist auch bekannt als Kalknatronglas.

Im Vergleich zu Borsilikatglas stellt Fensterglas ein kostengünstiges Material dar. Somit ist ein Bauteil, das ein erstes Substrat und ein zweites Substrat aus Fensterglas umfasst, kostengünstig herstellbar.

Bevorzugt ist das optoelektronische Bauelement eine organische, Licht emittierende Diode (OLED). Das optoelektronische Bauelement kann ferner eine organische Fotodiode oder eine organische Solarzelle sein.

Organische Bauelemente, insbesondere OLEDs, sind besonders anfällig gegen Umwelteinflüsse wie beispielsweise Wasserdampf oder Sauerstoff. Ein Abdichten des Bauteils gegen Wasserdampf und Sauerstoff mittels des Verbindungsmaterials ist daher insbesondere in Verbindung mit OLEDs besonders vorteilhaft.

Derartige niedrigschmelzende silberoxidhaltige Verbindungsmaterialien mit einem Füllstoff zur Reduzierung des Ausdehnungskoeffizienten ermöglichen insbesondere bei niedrigen Temperaturen einen sauerstoff- und wasserdampfdichten Verschluss des Bauteils. Als Folge des Ausschlusses von Wasserdampf und Sauerstoff erhöht sich mit Vorteil die Lebensdauer des organischen, optoelektronischen Bauelements. Ferner reduziert sich mit Vorteil die Menge an Getter beziehungsweise entfällt dieser ganz. Dadurch reduzieren sich mit Vorteil die Herstellungskosten.

Ein Verfahren zum Herstellen des erfindungsgemäßen Bauteils, das ein erstes Substrat, ein zweites Substrat, ein optoelektronisches Bauelement und ein Verbindungsmaterial aufweist, umfasst folgende Verfahrensschritte:
- Bereitstellen eines ersten Substrats, auf dem mindestens ein optoelektronisches Bauelement angeordnet ist, das mindestens ein organisches Material enthält,
- Bereitstellen eines zweiten Substrats,
- Anordnen eines Verbindungsmaterials auf dem ersten oder zweiten Substrat, wobei das Verbindungsmaterial Silberoxid mit einem Anteil zwischen 20 Gew-% und 70 Gew-% enthält, mit einem eingebrachten Füllstoff, der den thermischen Ausdehnungskoeffizienten des Verbindungsmaterials reduziert,
- Anordnen des ersten Substrats und des zweiten Substrats relativ zueinander derart, dass das optoelektronische Bauelement und das Verbindungsmaterial zwischen dem ersten Substrat und dem zweiten Substrat angeordnet sind, wobei das Verbindungsmaterial das optoelektronische Bauelement umschließt, und
- Aufschmelzen des Verbindungsmaterials, sodass das erste Substrat und das zweite Substrat mechanisch miteinander verbunden werden.

Das Verbindungsmaterial kann dabei auf dem zweiten Substrat angeordnet werden. In diesem Fall werden anschließend das erste Substrat und das zweite Substrat relativ zueinander derart angeordnet, dass das Verbindungsmaterial das optoelektronische Bauelement umschließt.

Alternativ kann das Verbindungsmaterial auf dem ersten Substrat angeordnet werden, wobei dabei das Verbindungsmaterial derart aufgebracht wird, dass das optoelektronische Bauelement von dem Verbindungsmaterial umschlossen wird. Dabei wird das optoelektronische Bauelement vorzugsweise nach dem Verbindungsmaterial auf das erste Substrat aufgebracht. Anschließend wird in diesem Fall das zweite Substrat relativ zu dem ersten Substrat derart angeordnet, dass das optoelektronische Bauelement und das Verbindungsmaterial zwischen dem ersten und dem zweiten Substrat angeordnet werden.

Vorteilhafte Ausgestaltungen des Verfahrens ergeben sich analog zu den vorteilhaften Ausgestaltungen des Bauteils und umgekehrt. Mittels des Verfahrens ist insbesondere ein hier beschriebenes Bauteil herstellbar. Das bedeutet, die in Verbindung mit dem Bauteil offenbarten Merkmale sind auch für das Verfahren offenbart.

Durch ein derartiges Verfahren kann ein Bauteil hergestellt werden, das ein organisches, optoelektronisches Bauelement umfasst, wobei das organische, optoelektronische Bauelement durch Verschließen des Bauteils gegen Umwelteinflüsse, wie beispielsweise Feuchtigkeit oder Luft, geschützt wird. Das Bauteil wird dabei mit Vorteil kostengünstig hergestellt, da sich durch die spezielle Zusammensetzung des Verbindungsmaterials, insbesondere der hohe Anteil an Silberoxid und dem Füllstoff zur Reduzierung des Ausdehnungskoeffizienten, die Menge an erforderlichen Getter reduziert, insbesondere mit Vorteil ganz entfällt.

Das Verbindungsmaterial weist zum Aufbringen auf eines der Substrate bevorzugt eine pastöse Konsistenz auf, sodass das Verbindungsmaterial startend an einem Punkt, vorzugsweise ohne Unterbrechung, so aufgetragen werden kann, dass es einen geschlossenen Rahmen bildet. Nach dem Aufbringen des Verbindungsmaterials wird dieser vorzugsweise zusammen mit dem Substrat, auf das es aufgebracht ist, gesintert.

Alternativ weist das Verbindungsmaterial eine pulverartige Konsistenz auf und wird auf eines der Substrate aufgerieselt.

Bevorzugt werden zum Aufschmelzen des Verbindungsmaterials Temperaturen von kleiner als 400° C verwendet. Insbesondere wird eine Zusammensetzung des Verbindungsmaterials verwendet, die ein Aufschmelzen bei Temperaturen von kleiner als 400° C ermöglichen. Bevorzugt erzeugt das Verbindungsmaterial bei Brenntemperaturen von beispielsweise 330° C und darunter eine gute Haftfestigkeit, wodurch bei derartigen Brenntemperaturen mit Vorteil bereits ein sauerstoff- und wasserdampfdichter Verschluss erzielt werden kann.

Bei einer bevorzugten Ausgestaltung erfolgt das Aufschmelzen des Verbindungsmaterials lokal durch eine umlaufende Strahlungsquelle, beispielsweise eines Laserstrahls. Dazu wird mittels eines Laserstrahls das Verbindungsmaterial temporär lokal erweicht und anschließend mittels Erkalten ausgehärtet.

Weitere Merkmale, Vorteile, bevorzugte Ausgestaltungen und Zweckmäßigkeiten des Bauteils und des Herstellungsverfahrens ergeben sich aus den im Folgenden in Verbindung mit den Figuren 1 bis 4 erläuterten Ausführungsbeispielen. Es zeigen:
- Figuren 1, 2 und 3: jeweils ein Ausführungsbeispiel eines erfindungsgemäßen Bauteils in schematischer Darstellung, und
- Figur 4: einen schematischen Querschnitt einer organischen, Licht emittierenden Diode (OLED).

Gleiche oder gleich wirkende Bestandteile sind jeweils mit den gleichen Bezugszeichen versehen. Die dargestellten Bestandteile, sowie die Größenverhältnisse der Bestandteile untereinander, sind nicht als maßstabsgerecht anzusehen.

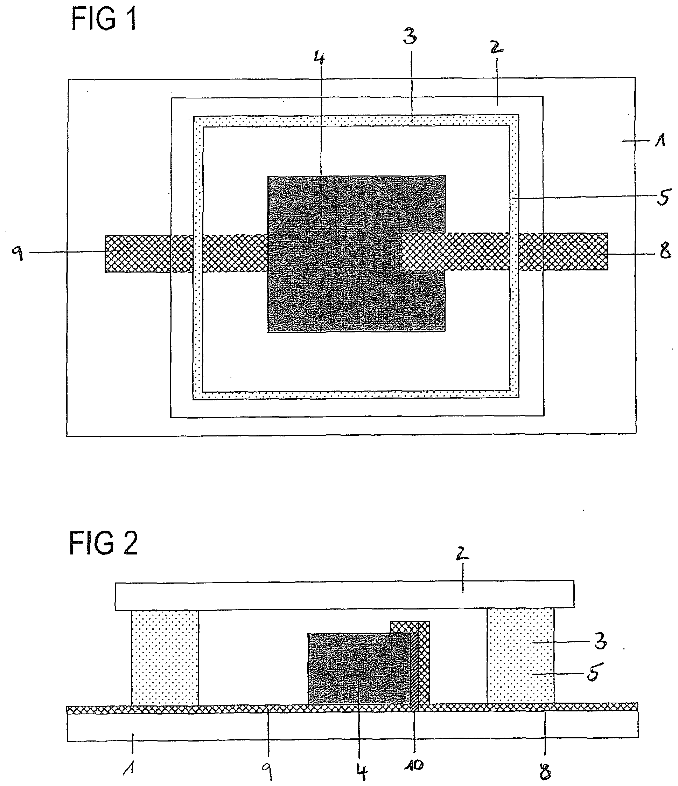

Figur 1 zeigt eine schematische Aufsicht auf ein Bauteil. Figur 2 stellt einen schematischen Querschnitt eines erfindungsgemäßen Bauteils dar, beispielsweise einen schematischen Querschnitt des Bauteils aus Figur 1. Das Bauteil weist ein erstes Substrat 1 und ein zweites Substrat 2 auf. Zwischen dem ersten Substrat 1 und dem zweiten Substrat 2 ist ein optoelektronisches Bauelement 4 angeordnet. Das optoelektronische Bauelement 4 enthält mindestens ein organisches Material.

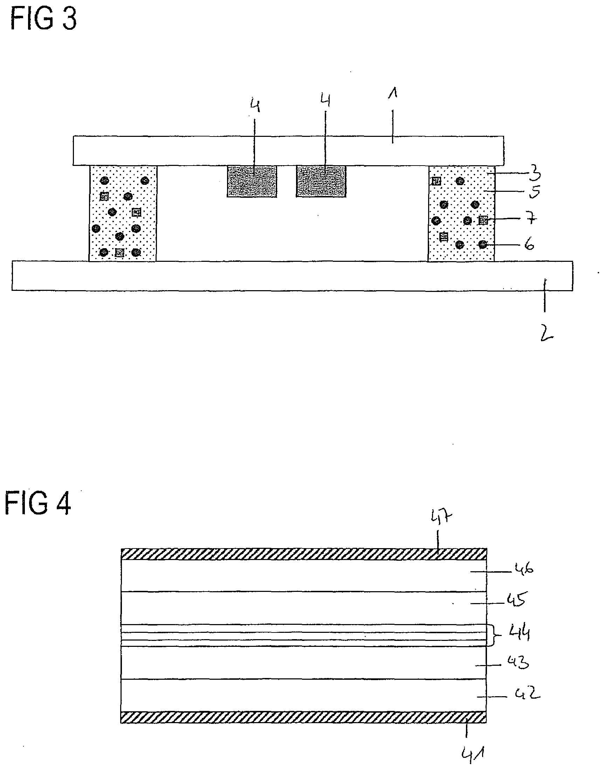

Bevorzugt ist das optoelektronische Bauelement 4 ein strahlungsemittierendes Bauelement, besonders bevorzugt eine organische, Licht emittierende Diode (OLED). Eine OLED zeichnet sich dadurch aus, dass mindestens eine Schicht der OLED ein organisches Material umfasst. Eine OLED weist beispielsweise folgenden Aufbau auf, der unter anderem in Figur 4 dargestellt ist:

Kathode 47, Elektronen induzierende Schicht 46, Elektronen leitende Schicht 45, emittierende Schichten 44, Löcher leitende Schicht 43, Löcher induzierende Schicht 42 und Anode 41.

Eine der Schichten, bevorzugt alle Schichten mit Ausnahme der Kathode und der Anode, umfasst ein organisches Material.

Das optoelektronische Bauelement 4 kann ferner eine Fotodiode oder eine Solarzelle sein, die mindestens ein organisches Material enthält.

Zwischen dem ersten Substrat 1 und dem zweiten Substrat 2 ist ein Verbindungsmaterial 3 angeordnet. Das Verbindungsmaterial 3 umschließt das optoelektronische Bauelement 4 rahmenförmig. Ferner verbindet das Verbindungsmaterial 3 das erste Substrat 1 und das zweite Substrat 2 mechanisch miteinander.

Das Verbindungsmaterial 3 umschließt vorzugsweise das optoelektronische Bauelement 4 vollständig.

Das Verbindungsmaterial 3 umfasst Silberoxid mit einem Anteil zwischen einschließlich 20 und 70 Gew-%. Besonders bevorzugt umfasst das Verbindungsmaterial 3 Silberoxid zu einem Anteil von einschließlich 50 bis einschließlich 70 Gew-%.

Ferner umfasst das Verbindungsmaterial zumindest einen Füllstoff 5, der den thermischen Ausdehnungskoeffizienten des Verbindungsmaterials 3 reduziert. Der Füllstoff 5 weist einen negativen thermischen Ausdehnungskoeffizienten auf. Der Anteil des Füllstoffs 5 am Verbindungsmaterial 3 liegt unter 30 Volumen-%. Durch den Füllstoff 5 kann mit Vorteil der thermische Ausdehnungskoeffizient des Verbindungsmaterials 3 derart angepasst werden, dass ein verbesserter sauerstoff- und wasserdampfdichter Verschluss des organischen, optoelektronischen Bauelements 4 erzielt werden kann. Insbesondere kann so ein dauerhaft dichter Verschluss des Bauteils erfolgen.

Durch eine derartige Zusammensetzung des Verbindungsmaterials 3 und durch das vollständige Umschließen des optoelektronischen Bauelements 4 mittels des Verbindungsmaterials 3 schützt das Verbindungsmaterial 3 das optoelektronische Bauelement 4 mit Vorteil vor Umwelteinflüssen. Unter Umwelteinflüssen ist insbesondere das Eindringen von Luft oder Feuchtigkeit in das Bauteil zu verstehen. Gerade bei optoelektronischen Bauelementen 4, die mindestens eine organische Schicht aufweisen, führt der Kontakt mit Luft oder Feuchtigkeit nachteilig zu einer Schädigung oder gar zu einer Zerstörung des organischen, optoelektronischen Bauelements 4. Das kann mit Vorteil durch die spezielle Zusammensetzung des Verbindungsmaterials 3 vermieden werden.

Das luftdichte Abschließen des Bauteils durch das Verbindungsmaterial 3 erhöht so mit Vorteil die Lebensdauer des organischen, optoelektronischen Bauelements 4 signifikant.

Ferner vereinfacht sich die Herstellung des Bauteils, da ein in eine Kavität eines der Substrate 1, 2 eingebrachtes Gettermaterial durch die spezielle Zusammensetzung des Verbindungsmaterials 3 nicht notwendig ist. Dadurch reduziert sich die Menge an erforderlichen Getter beziehungsweise entfällt dieser ganz. Ferner ist eine Bearbeitung eines der Substrate, insbesondere das Ausbilden einer Kavität und das Einbringen eines Getters, mit Vorteil nicht notwendig. Eine kostengünstige Herstellung derartiger Bauteile ermöglicht sich mit Vorteil.

Das erste Substrat 1 und das zweite Substrat 2 ist jeweils ein Glassubstrat aus Fensterglas. Fensterglas stellt im Vergleich zu anderen Glasmaterialien, wie beispielsweise Borsilikatglas, ein kostengünstiges.Material dar. Ein Bauteil, das ein erstes Substrat 1 und ein zweites Substrat 2 aus Fensterglas umfasst, ist somit mit Vorteil kostengünstig herstellbar.

Bevorzugt umfasst das Verbindungsmaterial 3 eine Glasfritte. Alternativ kann das Verbindungsmaterial 3 ein Glaslot umfassen.

Das Verbindungsmaterial 3 ist ein bleifreies und niedrigschmelzendes Glas.

Das erste Substrat 1 überragt das zweite Substrat 2 in Draufsicht auf das zweite Substrat 2 lateral, wie in Figur 1 dargestellt. Das bedeutet, dass das erste Substrat 1 und das zweite Substrat 2 unterschiedliche Größen der Grundflächen aufweisen, wobei das erste Substrat 1 eine größere Grundfläche aufweist als das zweite Substrat 2.

Elektrische Zuführungen 8, 9 des organischen, optoelektronischen Bauelements 4 erfolgen auf der dem optoelektronischen Bauelement 4 zugewandten Oberfläche des ersten Substrats 1. Dabei wird eine der elektrischen Zuführungen 8, 9 von einem Kontakt des optoelektronischen Bauelements 4, das sich auf der von dem ersten Substrat 1 abgewandten Seite des optoelektronischen Bauelements 4 befindet, über eine Seitenfläche des optoelektronischen Bauelements 4 zu dem ersten Substrat 1 geführt. Die Führung entlang der Seitenfläche des optoelektronischen Bauelements 4 ist dabei von den Schichten des optoelektronischen Bauelements 4 durch eine elektrisch isolierende Schicht 10 elektrisch isoliert.

Die elektrische Kontaktierung des optoelektronischen Bauelements 4 ist in Figur 2 schematisch dargestellt.

Dadurch, dass das erste Substrat 1 eine größere Grundfläche aufweist als das zweite Substrat 2, können die elektrischen Zuführungen 8, 9 des optoelektronischen Bauelements 4 aus dem Verbindungsmaterial 3 herausgeführt und dort elektrisch angeschlossen werden. Die elektrischen Zuführungen 8, 9 des optoelektronischen Bauelements 4 ragen lateral über das zweite Substrat 2 hinaus, sodass ein problemlos erreichbarer elektrischer Anschluss der elektrischen Zuführungen 8, 9 erfolgen kann.

Das in Figur 3 dargestellte Bauteil unterscheidet sich von dem in Figur 2 dargestellten Bauteil dadurch, dass zwischen dem ersten Substrat 1 und dem zweiten Substrat 2 mehrere organische, optoelektronische Bauelemente 4 angeordnet sind. Das Bauteil ist demnach nicht auf die Verwendung lediglich eines optoelektronischen Bauelements 4 eingeschränkt. Die Anzahl der organischen, optoelektronischen Bauelemente 4 kann in Hinsicht auf den Verwendungszweck des Bauteils variieren. Ferner enthält das Verbindungsmaterial 3 im Unterschied zu dem Bauteil aus Figur 2 einen weiteren Füllstoff 6, der Strahlung absorbiert. Besonders bevorzugt absorbiert der weitere Füllstoff 6 Strahlung im infraroten und/oder ultravioletten Wellenlängenbereich. Mit Vorteil können so Sonneneinstrahlungen, die das optoelektronische Bauelement 4 nachteilig schädigen können, vermieden werden.

Beispielsweise ist der weitere Füllstoff 6 Vanadiumoxid, ein Spinell oder eine Spinellverbindung.

Ein weiterer Unterschied des Bauteils aus Figur 3 zu dem Bauteil aus Figur 2 ist, dass das Verbindungsmaterial 3 einen weiteren Stoff 7 enthält, der als Abstandshalter für das erste Substrat 1 und das zweite Substrat 2 zueinander dient. Alternativ kann in dem Bauteil ein Abstandshalter integriert sein, der nicht in dem Verbindungsmaterial 3 angeordnet ist, sondern zwischen optoelektronischem Bauelement 4 und Verbindungsmaterial 3 angeordnet ist (nicht dargestellt).

Abstandshalter 7 dienen dazu, gezielt einen festen Abstand zwischen erstem Substrat 1 und zweitem Substrat 2 festzulegen. Dadurch kann vermieden werden, dass während des Prozesses des Aufweichens des Verbindungsmaterials 3 die Substrate 1, 2 den durch die Abstandshalter 7 festgelegten Abstand nicht unterschreiten, sodass die organischen, optoelektronischen Bauelemente 4 während des Herstellungsverfahrens nicht durch einen zu geringen Abstand zwischen dem ersten Substrat 1 und dem zweiten Substrat 2 beschädigt werden.

Das Erweichen des Verbindungsmaterials 3 erfolgt vorzugsweise mit Temperaturen von kleiner als 400° C.

Beispielsweise kann ein Verfahren zur Herstellung eines Bauteils gemäß Figur 1, Figur 2 oder Figur 3 die im Folgenden genannten Verfahrensschritte aufweisen:
Auf ein zweites Substrat 2 wird beispielsweise rahmenförmig ein Verbindungsmaterial 3, beispielsweise eine Glasfritte, aufgebracht, beispielsweise aufgerieselt, bevorzugt aufgesintert. Ferner wird ein erstes Substrat 1 bereitgestellt, auf dem ein organisches, optoelektronisches Bauelement 4 aufgebracht ist.

Das Verbindungsmaterial 3 enthält Silberoxid mit einem Anteil einschließlich zwischen 20 Gew-% und 70 Gew-% und zumindest einen Füllstoff 5, der den thermischen Ausdehnungskoeffizienten des Verbindungsmaterials 3 reduziert. Der Füllstoff 5 kann dabei direkt in dem Verbindungsmaterials 3 enthalten sein oder nachträglich zugemischt werden.

Bevorzugt werden in das Verbindungsmaterial 3 Abstandshalter 7 und weitere Füllstoffe 6, die insbesondere Strahlung absorbieren, eingebracht.

Auf das zweite Substrat 2 wird nun das.erste Substrat 1 gelegt. Das erste Substrat 1 wird so auf das zweite Substrat 2 gelegt, dass das organische, optoelektronische Bauelement 4 zwischen erstem Substrat 1 und zweitem Substrat 2 angeordnet ist. Ferner werden das erste Substrat 1 und das zweite Substrat 2 derart zueinander angeordnet, dass das Verbindungsmaterial 3 das organische, optoelektronische Bauelement 4 umläuft, beispielsweise rahmenförmig umschließt.

Anschließend kann mittels Temperaturen von kleiner als 400° C das Verbindungsmaterial 3 so aufgeschmolzen werden, dass das erste Substrat 1 und das zweite Substrat 2 mechanisch miteinander verbunden werden.

Durch die spezielle Zusammensetzung des Verbindungsmaterials 3 kann mit Vorteil eine hermetisch dichte Verbindung zwischen erstem Substrat 1 und zweitem Substrat 2 gebildet werden. Damit ermöglicht sich mit Vorteil ein sauerstoff- und wasserdampfdichter Verschluss der OLED, wodurch sich mit Vorteil die Lebensdauer des Bauteils erhöht. Ferner können Getter und damit verbundene teure Bearbeitungsschritte vermieden werden. Eine vereinfachte und kostengünstige Herstellung hermetisch dichter Bauteile ist so mit Vorteil möglich.

## Patentansprüche

1. Bauteil, das ein erstes Substrat (1) und ein zweites Substrat (2) aufweist, wobei
- auf dem ersten Substrat (1) mindestens ein optoelektronisches Bauelement (4) angeordnet ist, das mindestens ein organisches Material enthält,
- das erste Substrat (1) und das zweite Substrat (2) relativ zueinander derart angeordnet sind, dass das optoelektronische Bauelement (4) zwischen dem ersten Substrat (1) und dem zweiten Substrat (2) angeordnet ist,
- ein Verbindungsmaterial (3) zwischen dem ersten Substrat (1) und dem zweiten Substrat (2) angeordnet ist, welches das optoelektronische Bauelement (4) umschließt und das erste und zweite Substrat (1, 2) mechanisch miteinander verbindet,
- das Verbindungsmaterial (3) Silberoxid zu einem Anteil von einschließlich 20 bis einschließlich 70 Gew.-% umfasst,
- das Verbindungsmaterial (3) zumindest einen Füllstoff (5) umfasst, der den thermischen Ausdehnungskoeffizienten des Verbindungsmaterials (3) reduziert, wobei der Füllstoff (5) einen negativen thermischen Ausdehnungskoeffizienten aufweist und ein Anteil des Füllstoffs (5) am Verbindungsmaterial (3) unter 30 Volumen-% liegt,
- das Verbindungsmaterial (3) ein bleifreies Glas umfasst und eine Komponente dieses Glases Vanadiumoxid ist,
- die Substrate (1, 2) aus einem Kalknatronglas hergestellt sind,
- elektrische Zuführungen (8, 9) des optoelektronischen Bauelements (4) auf einer dem optoelektronischen Bauelement (4) zugewandten Oberfläche des ersten Substrats (1) erfolgen und eine der elektrischen Zuführungen (8, 9) von einem Kontakt des optoelektronischen Bauelements (4), welcher sich auf der von dem ersten Substrat (1) abgewandten Seite des optoelektronischen Bauelements (4) befindet, über eine Seitenfläche des optoelektronischen Bauelements (4) zu dem ersten Substrat (1) geführt ist,
- die elektrischen Zuführungen (8, 9) des optoelektronischen Bauelements (4) aus dem Verbindungsmaterial (3) herausgeführt sind, sodass das Verbindungsmaterial (3) über die elektrischen Zuführungen (8, 9) auf dem ersten Substrat (1) hinweg geführt ist, und
- das erste Substrat (1) das zweite Substrat (2) lateral überragt, in Draufsicht auf das zweite Substrat (2) gesehen, sodass das erste Substrat (1) eine größere Grundfläche aufweist als das zweite Substrat (2).

2. Bauteil gemäß Anspruch 1, wobei
das Verbindungsmaterial (3) ein niedrigschmelzendes Glas umfasst und ein Erweichungspunkt des Glases für Einbrenntemperaturen bei unterhalb 350° C liegt.

3. Bauteil gemäß einem der vorhergehenden Ansprüche, wobei das Verbindungsmaterial (3) eine Glasfritte oder ein Glaslot umfasst.

4. Bauteil gemäß einem der vorhergehenden Ansprüche, wobei das Verbindungsmaterial (3) einen weiteren Füllstoff (6) enthält, der Strahlung absorbiert.

5. Bauteil gemäß Anspruch 4, wobei
der weitere Füllstoff (6) ein Spinell oder eine Spinellverbindung ist.

6. Bauteil gemäß einem der vorhergehenden Ansprüche, wobei das Verbindungsmaterial (3) zumindest einen weiteren Stoff (7) enthält, der als Abstandshalter für das erste und zweite Substrat zueinander dient.

7. Bauteil gemäß einem der vorhergehenden Ansprüche, wobei das optoelektronische Bauelement (4) eine organische Licht emittierende Diode (OLED) ist.

8. Verfahren zum Herstellen eines Bauteils gemäß Anspruch 1 mit den Verfahrensschritten:
- Bereitstellen des ersten Substrats (1), auf dem das mindestens eine optoelektronische Bauelement (4) angeordnet ist, das das mindestens eine organische Material enthält,
- Bereitstellen des zweiten Substrats (2),
- Anordnen des Verbindungsmaterials (3) auf dem ersten oder zweiten Substrat (1, 2), wobei das Verbindungsmaterial (3) Silberoxid zu einem Anteil von einschließlich 20 bis einschließlich 70 Gew.-% umfasst, und in das Verbindungsmaterial (3) der zumindest eine Füllstoff (5) eingebracht wird, der den thermischen Ausdehnungskoeffizienten des Verbindungsmaterials (3) reduziert,
- Anordnen des ersten Substrats (1) und des zweiten Substrats (2) relativ zueinander derart, dass das optoelektronische Bauelement (4) und das Verbindungsmaterial (3) zwischen dem ersten Substrat (1) und dem zweiten Substrat (2) angeordnet sind, wobei das Verbindungsmaterial (3) das optoelektronische Bauelement (4) umschließt, und
- Aufschmelzen des Verbindungsmaterials (3), sodass das erste Substrat (1) und das zweite Substrat (2) mechanisch miteinander verbunden werden.

9. Verfahren gemäß dem vorhergehenden Anspruch, wobei zum Aufschmelzen Temperaturen von kleiner als 400°C verwendet werden, und
wobei das Verbindungsmaterial (3) beim Aufbringen auf eines der Substrate (1, 2) eine pastöse Konsistenz aufweist und das Verbindungsmaterial (3), startend an einem Punkt, ohne Unterbrechung so aufgetragen wird, dass es einen geschlossenen Rahmen bildet, und
wobei nach dem Aufbringen das Verbindungsmaterial (3) zusammen mit demjenigen Substrat (1, 2), auf das es aufgebracht ist, gesintert wird.

## Claims

1. Component comprising a first substrate (1) and a second substrate (2), wherein
- at least one optoelectronic component (4) containing at least one organic material is arranged on the first substrate (1),
- the first substrate (1) and the second substrate (2) are arranged relative to one another such that the optoelectronic component (4) is arranged between the first substrate (1) and the second substrate (2),
- a bonding material (3) is arranged between the first substrate (1) and the second substrate (2), which encloses the optoelectronic component (4) and bonds the first and second substrates (1, 2) together mechanically,
- the bonding material (3) comprises silver oxide in a proportion of 20 to 70 wt.% inclusive,
- the bonding material (3) comprises at least one filler material (5), which reduces the coefficient of thermal expansion of the bonding material (3), wherein the filler material (5) has a negative coefficient of thermal expansion and a proportion of the filler material (5) in the bonding material (3) is below 30 vol.%,
- the bonding material (3) comprises a lead-free glass and one component of said glass is vanadium oxide,
- the substrates (1, 2) are produced from a soda lime glass
- electrical feeds (8, 9) of the optoelectronic component (4) take place on a surface of the first substrate (1) facing the optoelectronic component (4), and one of the electrical feeds (8, 9) is guided from a contact of the optoelectronic component (4), which is located on the side of the optoelectronic component (4) facing away from the first substrate (1), via a side face of the optoelectronic component (4) to the first substrate (1),
- the electrical feeds (8, 9) of the optoelectronic component (4) are guided out of the bonding material (3), so that the bonding material (3) is guided over the electrical feeds (8, 9) on the first substrate (1), and
- the first substrate (1) projects laterally beyond the second substrate (2), in a plan view of the second substrate (2), so that the first substrate (1) has a larger base area than the second substrate (2).

2. Component according to claim 1, wherein
the bonding material (3) comprises a low melting point glass having a softening point for stoving temperatures of below 350°C.

3. Unit according to any one of the preceding claims, wherein the bonding material (3) is a glass frit or a glass solder.

4. Unit according to any one of the preceding claims, wherein the bonding material (3) contains a further filler material (6) which absorbs radiation.

5. Unit according to claim 4, wherein
the further filler material (6) is a spinel compound.

6. Unit according to any one of the preceding claims, wherein the bonding material (3) contains at least one further substance (7), which serves as a spacer to space apart the first and second substrates from one another.

7. Unit according to any one of the preceding claims, wherein the optoelectronic component (4) is an organic light-emitting diode (OLED).

8. Method of producing a unit according claim 1, comprising the method steps:
- providing a first substrate (1), on which at least one optoelectronic component (4) is arranged, which component contains at least one organic material,
- providing a second substrate (2),
- arranging a bonding material (3) on the first or second substrate (1, 2), wherein the bonding material (3) comprises silver oxide in a proportion of 20 to 70 wt.% inclusive, and at least one filler material (5) is introduced into the bonding material (3), which filler material reduces the coefficient of thermal expansion of the bonding material (3),
- arranging the first substrate (1) and the second substrate (2) relative to one another in such a way that the optoelectronic component (4) and the bonding material (3) are arranged between the first substrate (1) and the second substrate (2), wherein the bonding material (3) enclosing the optoelectronic component (4), and
- fusing the bonding material (3), such that the first substrate (1) and the second substrate (2) are joined together mechanically.

9. Method according to the preceding claim, wherein temperatures of less than 400°C are used for fusing, and wherein the bonding material (3) has a pasty consistency during application to one of the substrates (1, 2) and the bonding material (3) is applied starting at one point without interruption so as to form a closed frame, and
wherein after the application, the connecting material (3) is sintered together with the substrate (1, 2) to which it is applied.

## Revendications

1. Composant comprenant un premier substrat (1) et un second substrat (2), dans lequel
- au moins un composant optoélectronique (4) contenant au moins un matériau organique est disposé sur le premier substrat (1),
- le premier substrat (1) et le second substrat (2) sont disposés l'un par rapport à l'autre de manière à ce que le composant opto-électronique (4) soit disposé entre le premier substrat (1) et le deuxième substrat (2),
- un matériau de liaison (3) est prévu entre le premier substrat (1) et le second substrat (2) qui enferme le composant optoélectronique (4) et relie mécaniquement les premier et second substrats (1, 2),
- le matériau de liaison (3) comprend de l'oxyde d'argent en une proportion compris entre 20 et 70% en poids,
- le matériau de liaison (3) comprend au moins un agent de charge (5) modifiant le coefficient de dilatation thermique du matériau de liaison (3), l'agent de charge (5) présentant un coefficient de dilatation thermique négatif, une proportion de l'agent de charge (5) sur le matériau de liaison (3) étant inférieure à 30% en volume,
- le matériau de liaison (3) comprend un verre exempt de plomb, un composant dudit verre étant l'oxyde de vanadium,
- les substrats (1, 2) sont réalisés en un verre silico-sodo-calcique,
- des dispositifs d'alimentation électrique (8, 9) du composant optoélectronique (4) sont prévus sur une surface du premier substrat (1) orientée vers le composant optoélectronique (4), l'un des dispositifs d'alimentation électrique (8, 9) étant amené depuis un contact du composant optoélectronique (4) qui se trouve sur la face du composant optoélectronique (4) opposée au premier substrat (1) vers le premier substrat (1), via une face latérale du composant optoélectronique (4),
- les dispositifs d'alimentation électrique (8, 9) du composant optoélectronique (4) font saillie du matériau de liaison (3) de sorte que le matériau de liaison (3) soit guidé au-delà des dispositifs d'alimentation électrique (8, 9) disposés sur le premier substrat (1), et
- le premier substrat (1) dépasse latéralement le second substrat (2), vu de dessus sur le second substrat (2), de sorte que le premier substrat (1) présente une superficie plus importante que le second substrat (2).

2. Composant selon la revendication 1, dans lequel le matériau de liaison (3) comprend un verre à faible point de fusion et un point de ramollissement pour des températures de cuisson est inférieur à 350°C.

3. Composant selon l'une des revendications précédentes, dans lequel le matériau de liaison (3) comprend une fritte de verre ou une brasure de verre.

4. Composant selon l'une des revendications précédentes, dans lequel le matériau de liaison (3) comprend un agent de charge (6) supplémentaire absorbant la radiation.

5. Composant selon la revendication 4, dans lequel l'agent de charge (6) supplémentaire est un spinelle ou un composé de spinelle.

6. Composant selon l'une des revendications précédentes, dans lequel le matériau de liaison (3) contient au moins une autre substance (7) qui sert d'espaceur aux premier et second substrats l'un par rapport à l'autre.

7. Composant selon l'une des revendications précédentes, dans lequel le composant optoélectronique (4) est une diode électroluminescente organique (OLED).

8. Procédé de fabrication d'un composant selon la revendication 1, comprenant les étapes de procédé suivantes:
- mise à disposition du premier substrat (1) sur lequel est disposé l'au moins un composant optoélectronique (4) contenant l'au moins un matériau organique,
- mise à disposition du second substrat (2),
- disposition du matériau de liaison (3) sur le premier ou second substrat (1, 2), le matériau de liaison (3) comprenant de l'oxyde d'argent d'une proportion comprise entre 20 et 70% en poids, l'au moins un agent de charge (5) étant incorporée au matériau de liaison (3) qui réduit le coefficient thermique de dilatation du matériau de liaison (3),
- disposition des premier (1) et second substrats (2) l'un par rapport à l'autre de telle sorte que le composant optoélectronique (4) et le matériau de liaison (3) soient disposés entre le premier substrat (1) et le second substrat (2), le matériau de liaison (3) enfermant le composant optoélectronique (4), et
- fusion du matériau de liaison (3) de sorte que le premier substrat (1) et le second substrat (2) soient reliés mécaniquement l'un à l'autre.

9. Procédé selon la revendication précédente, dans lequel des températures inférieures à 400°C sont mises en oeuvre pour la fusion, et
le matériau de liaison (3), lors de son application sur l'un des substrats (1, 2) présente une consistance pâteuse (1, 2), le matériau de liaison (3) étant appliqué, en partant d'un point de manière continue, de telle sorte qu'il définit un cadre fermé, et
après son application, le matériau de liaison (3) est fritté ensemble avec le substrat (1, 2) sur lequel il a été déposé.
